# EUROPEAN PATENT SPECIFICATION

(11) **EP 2 114 114 B1**
(45) Date of publication and mention of the grant of the patent: **15.05.2013**
(21) Application number: 09156731.3
(22) Date of filing: 30.03.2009
(51) Int. Cl.: H05K 1/09, H05K 3/10, H05K 3/12, C09D 11/00, H01L 21/48

(54) **Bimetallic nanoparticles for conductive ink applications**
Bimetallische Nanopartikel für leitfähige Tintenanwendungen
Nanoparticules bimétalliques pour les applications d'encre conductrices

(30) Priority: 01.05.2008 US 113628
(43) Date of publication of application: 04.11.2009
(73) Proprietor: Xerox Corporation, Rochester, New York 14644 (US)
(72) Inventor: Chopra, Naveen, Oakville Ontario L6H 5W4 (CA); Wu, Yiliang, Oakville Ontario L6H 0C6 (CA); Kazmaier, Peter M., Mississauga Ontario L5L 1E5 (CA)
(74) Representative: Jones, Helen M.M.

(56) References cited:
- US-A1- 2003 148 024
- US-A1- 2007 131 912

## Description

Disclosed in commonly assigned U.S. Patent Application No. 11/948,098 to Naveen Chopra et al. filed November 30, 2007, is a copper nanoparticle ink composition, comprising: copper nanoparticles; a substituted dithiocarbonate stabilizer; and a carrier solvent; wherein the stabilizer stabilizes the copper nanoparticles. Also disclosed is a process for forming a copper nanoparticle ink composition, comprising: providing a substituted dithiocarbonate stabilizer; and stabilizing a copper nanoparticle dispersion with the substituted dithiocarbonate stabilizer in a solvent medium.

Disclosed in commonly assigned U.S. Patent Application No. 12/169,090 (Xerox Docket No. 20071925-US-NP) to Naveen Chopra et al. filed 8 July 2008 is a bimodal copper nanoparticle composition includes first copper nanoparticles having an average diameter of from about 50 nm to about 1000 nm, and second stabilized copper nanoparticles having an average diameter of from about 0.5 nm to about 20 nm, the second stabilized copper nanoparticles including copper cores having a stabilizer attached to the surfaces thereof, wherein the stabilizer is a substituted dithiocarbonate.

Fabrication of electronic circuit elements using liquid deposition techniques is of profound interest as such techniques provide potentially low-cost alternatives to conventional mainstream amorphous silicon technologies for electronic applications such as thin-film transistors (TFTs), light-emitting diodes (LEDs), RFID tags and antennas, photovoltaics, etc. However the deposition and/or patterning of functional electrodes, pixel pads, and conductive traces, lines and tracks which meet the conductivity, processing, and cost requirements for practical applications have been a great challenge.

Solution-processable conductors are of great interest for use in such electronic applications. Metal nanoparticle-based inks represent a promising class of materials for printed electronics. However, most metal nanoparticles, such as silver and gold metal nanoparticles, require large molecular weight stabilizers to ensure proper solubility and stability in solution. These large molecular weight stabilizers inevitably raise the annealing temperatures of the metal nanoparticles above 200 °C in order to burn off the stabilizers, which temperatures are incompatible with most low-cost plastic substrates such as polyethylene terephthalate (PET) and polyethylene naphthalate (PEN) that the solution may be coated onto and can cause damage thereto.

Further, the use of lower molecular weight stabilizers can also be problematic, as smaller size stabilizers often do not provide desired solubility and often fail to effectively prevent coalescence or aggregation of the metal nanoparticles before use.

The printing of copper nanoparticles is currently being researched as a possible means to produce an electronic feature on a substrate because copper nanoparticle inks are cheap to produce. However, at present, copper features are typically prepared by (1) electroplating copper ions onto an existing metal surface using corrosive and toxic reagents such as sodium hydroxide and cyanide or (2) various etched foil methods, which are both wasteful and incompatible with paper substrates. Furthermore, copper nanoparticle inks are often unstable and require an inert/reducing atmosphere during preparation and annealing to prevent the spontaneous oxidation to nonconductive copper (II) oxide or copper (I) oxide. Moreover, large copper nanoparticles (greater than 50 nm) require annealing temperatures greater than 1000 °C, which is incompatible with most paper and plastic substrates.

One of the advantages achieved by embodiments herein is that the combination of small metal nanoparticles with different, larger metal nanoparticles produces metal nanoparticles that (1) are cheaper to produce where expensive second metal nanoparticles can be used in reduced quantities, (2) can be prepared faster as only the smaller second metal nanoparticles, with a low annealing temperature, require annealing and (3) perform reliably since the risk of incomplete sintering or breaks is greatly reduced.

U.S. Patent Publication No. 2004/0175548 A1 (Lawrence et al.) describes a conductive ink that is suitable for gravure or flexographic printing and includes a carboxylic acid or anhydride-functional aromatic vinyl polymer and an electrically conductive material that may be either a particulate material or a flake material, particularly a conductive flake material having an aspect ratio of at least about 5:1.

Dhas et al., Chem. Mater., 10, 1446-52, (1998) discusses a method for metallic copper nanoparticle synthesis using an argon/hydrogen (95:5) atmosphere in order to avoid formation of impurities, such as copper oxide.

Volkman et al., Mat. Res. Soc. Proc. Vol. 814, 17.8.1-17.8.6 (2004) describes processes for forming silver and copper nanoparticles, and discusses the optimization of the printing/annealing processes to demonstrate plastic-compatible low-resistance conductors.

Jana et al., Current Science vol. 79, No. 9 (November 10, 2000) describes preparation of cubic copper particles, in which cube-shaped copper nanoparticles in the size range of about 75 to 250 nm are formed from smaller spherical copper particles.

Wu et al., Mater. Res. Soc. Symp. Proc. Vol. 879 E, Z6.3.1-Z6.3.6 (2005) describes a solution-phase chemical reduction method with no inert gas protection, for preparing a stable copper nanoparticle colloid with average particle size of 3.4 nm and narrow size distribution using ascorbic acid as both a reducing agent and an antioxidant to reduce copper precursor and effectively prevent the general oxidation process occurring to the newborn nanoparticles.

Chen et al., Nanotechnology, 18, 175706 (2007) describes silver nanoparticle synthesis in an aqueous solution and capped with an inclusion complex of octadecanethiol (ODT) and *p*-sulfonated calix[4]arene (pSC4).

U.S. Patent Publication No. 2006/0053972 A1 (Liu et al.) describes a process for producing copper nanoparticles in the form of a solid powder, by first reacting an aqueous solution containing a reductant with an aqueous solution of a copper salt, followed by adding an apolar organic solution containing the extracting agent, then finally post-treating the reaction product to obtain copper nanoparticles.

U.S. Patent Publication No. 2005/0078158 A1 by Magdassi et al. describes compositions for use in inkjet printing onto a substrate via a water based dispersion including metallic nanoparticles and appropriate stabilizers. Magdassi also describes methods for producing such compositions and methods for their use in ink jet printing onto suitable substrates.

U.S. Patent Publication No. 2004/0089101 A1 by Winter et al. describes methods of making monodisperse nanocrystals via reducing a copper salt with a reducing agent, providing a passivating agent including a nitrogen and/or an oxygen donating moiety, and isolating the copper nanocrystals. Winter also describes methods for making a copper film via the steps of applying a solvent including copper nanocrystals onto a substrate and heating the substrate to form a film of continuous bulk copper from the nanocrystals. Finally, Winter also describes methods for filling a feature on a substrate with copper via the steps of applying a solvent including copper nanocrystals onto the featured substrate and heating the substrate to fill the feature by forming continuous bulk copper in the feature.

U.S. Patent Application No. 2003/0180451 by Kodas et al. discloses a precursor composition for the deposition and formation of an electrical feature such as a conductive feature. The precursor composition advantageously has a low viscosity enabling deposition using direct-write tools. The precursor composition also has a low conversion temperature. A particularly preferred precursor composition includes copper metal for the formation of highly conductive copper features.

US 2007/0131912 describes an adhesive comprising a cured low modulus elastomer; and metallurgically-bonded micron-sized metal particles and nano-sized metal particles, wherein the adhesive is electrically conductive.

The above-described methods for creating metallic nanoparticles suffer from several drawbacks. As previously described, using silver nanoparticles is costly. Moreover, most of the methods for copper nanoparticle synthesis require a reducing/inert atmosphere to avoid oxidation of the copper particles. The methods described that do not require a reducing/inert atmosphere suffer from the limitations that the particles formed are too large to be annealed at a lower temperature (<200°C). Moreover, the requirements for using copper nanoparticles in large volumes of chipless RFID tags are: stability under atmospheric conditions, small particle size, and high throughput yield. Thus, there exists a need for a cheaper method of producing conductive inks that can be used for a range of applications, and that can be more easily and cost-effectively produced and used.

Disclosed generally are methods for forming a conductive feature on a substrate by providing a depositing solution, depositing the depositing solution onto the substrate and heating the depositing solution to a temperature below about 140 °C. As a result of the lower annealing temperature, the depositing solution can be used to form conductive features on a wider range of substrates.

In embodiments, the application is directed to a method of forming conductive features on a substrate, the method comprising: providing a depositing solution, liquid depositing the depositing solution onto a substrate, and heating the depositing solution to a temperature below about 140 °C. The depositing solution is comprised of a mixture of first metal nanoparticles and second metal nanoparticles or a combination of first metal nanoparticles and a soluble second metal nanoparticle precursor. If the depositing solution is a combination of first metal nanoparticles and the soluble second metal nanoparticle precursor, the method further comprises: subjecting the soluble second metal nanoparticle precursor to a temperature at or below 90 °C before the heating to a temperature below about 140 °C to destabilize the soluble second metal nanoparticle precursor and form the second metal nanoparticles. The average diameter of the first metal nanoparticles is from about 50 nm to about 800 nm and the average diameter of the second metal nanoparticles is from about 0.5 nm to about 20 nm.

In further embodiments, the application is directed to a method of forming conductive features on a substrate, the method comprising: providing a depositing solution; wherein the depositing solution is comprised of a mixture of first metal nanoparticles and second metal nanoparticles, liquid depositing the depositing solution onto a substrate, and heating the depositing solution to a temperature below about 140 °C, and wherein the average diameter of the first metal nanoparticles is from about 50 nm to about 800 nm and the average diameter of the second metal nanoparticles is from about 0.5 nm to about 20 nm.

In further embodiments, the application is directed to a method of forming conductive features on a substrate, the method comprising: providing a depositing solution, wherein the depositing solution is comprised of a combination of first metal nanoparticles and a soluble second metal nanoparticle precursor, liquid depositing the depositing solution onto a substrate, subjecting the depositing solution to a temperature below about 90 °C to destabilize the soluble second metal nanoparticle precursor to form second metal nanoparticles, and following the formation of the second metal nanoparticles, heating the first metal nanoparticles and the second metal nanoparticles to a temperature below about 140 °C, and wherein the average diameter of the first metal nanoparticles is from about 50 nm to about 800 nm and the average diameter of the second metal nanoparticles is from about 0.5 nm to about 20 nm.

In still further embodiments, this application is directed a metallic nanoparticle solution comprised of: a first metal nanoparticle and a second metal material selected from one of a second metal nanoparticle and a second metal nanoparticle precursor that forms a second metal nanoparticle upon heating, and wherein the average diameter of the first metal nanoparticle is from about 50 nm to about 800 nm and the average diameter of the second metal nanoparticle, when present or formed, is from about 0.5 nm to about 20 nm.

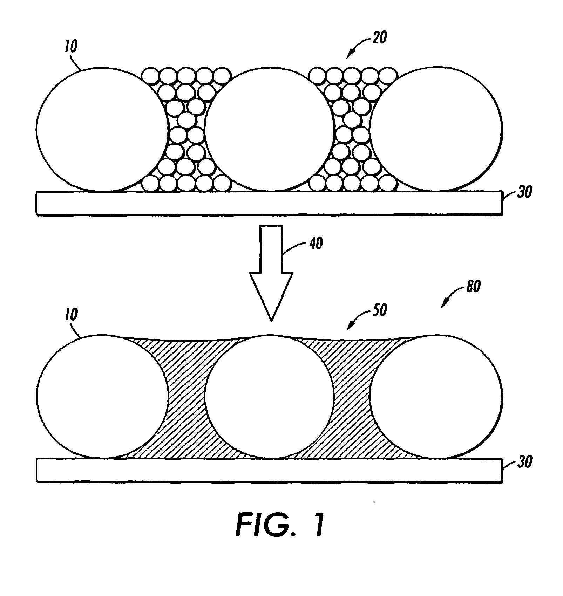

Figure 1 illustrates an embodiment where a depositing solution comprised of first metal nanoparticles with an average diameter of about 50 nm to about 800 nm and second metal nanoparticles with an average diameter of about 0.5 nm to about 20 nm are deposited on a substrate and heated to form a conductive path between the first metal nanoparticles and the second nanoparticles.

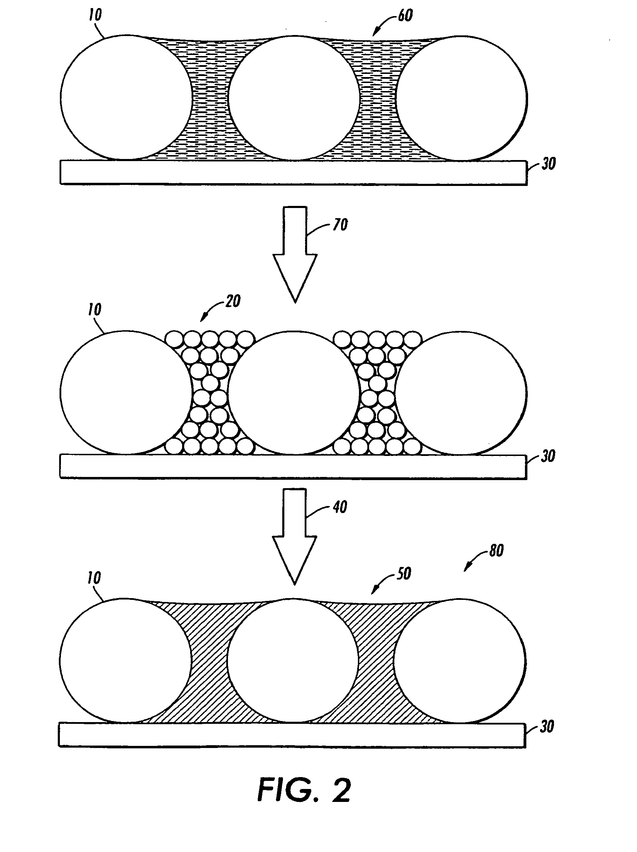

Figure 2 illustrates an embodiment where a depositing solution comprised of first metal nanoparticles with an average diameter of about 50 nm to about 800 nm and a soluble second metal nanoparticle precursor are deposited onto a substrate, heated to destabilize the soluble second metal nanoparticle precursor to form second metal nanoparticles with an average diameter of about 0.5 nm to about 20 nm and to form a conductive path between the larger, first metal nanoparticles and the smaller, second nanoparticles.

Described is a method of forming conductive features on a substrate by providing a depositing solution and liquid depositing the depositing solution onto a substrate. Following deposition, the depositing solution is heated to a temperature below about 140 °C to anneal the second metal nanoparticles and remove any reaction by-products. The depositing solution may be comprised of a mixture of first metal nanoparticles and second metal nanoparticles or a combination of first metal nanoparticles and a soluble second metal nanoparticle precursor. If the depositing solution is comprised of the first metal nanoparticles and a soluble second metal nanoparticle precursor, the method further comprises heating the soluble second metal nanoparticle precursor to a temperature at or below 90 °C before annealing to destabilize the soluble second metal nanoparticle precursor and form the second metal nanoparticles. Furthermore, the average diameter of the first metal nanoparticles is about 50 nanometers (nm) to about 800 nm and the average diameter of the second metal nanoparticles is about 0.5 nm to about 20 nm.

In embodiments, the depositing solution is comprised of a mixture of two metal nanoparticle species: first metal nanoparticles with an average diameter of about 50 nm to about 800 nm such as, for example, from about 50 nm to about 600 nm, from about 50 nm to about 400 nm, from about 50 nm to about 200 nm or from about 60 nm to about 100 nm and second nanoparticles with an average diameter of about 0.5 nm to 20 nm such as, for example, from about 1 nm to about 18 nm, from about 1 nm to about 15 nm or from about 2 nm to about 10 nm. The first metal nanoparticles are different from the second metal nanoparticles.

In alternative embodiments, the depositing solution is comprised of a first metal nanoparticle species and a soluble second metal nanoparticle precursor. The first metal nanoparticles have an average diameter of, for example, from about 50 nm to about 800 nm such as, for example, from about 50 nm to about 600 nm, from about 50 nm to about 400 nm, from about 50 nm to about 200 nm or from about 60 nm to about 100 nm. Heating the depositing solution to a temperature at or below 90 °C destabilizes the soluble second metal nanoparticle precursor to form the second metal nanoparticle with an average diameter of, for example, from about 0.5 to 20 nm, from about 1 nm to about 18 nm, from about 1 nm to about 15 nm or from about 2 nm to about 10 nm.

The first metal nanoparticles have a particle size of, for example, about 50 nm to about 800 nm such as, for example, from about 50 nm to about 600 nm, from about 50 nm to about 400 nm, from about 50 nm to about 200 nm or from about 60 nm to about 100 nm. Particle size herein refers to the average diameter of metal particles, as determined by TEM (transmission electron microscopy) or other suitable method.

The second metal nanoparticles have a particle size of from about 0.5 nm to about 20 nm, such as, for example, from about 1 nm to about 18 nm, from about 1 nm to about 15 nm, from about 2 nm to about 10 nm, from about 2 nm to about 8 nm or from about 2 nm to about 6 nm.

Examples of the first metal nanoparticles include copper nanoparticles, silver nanoparticles, gold nanoparticles, platinum nanoparticles, palladium nanoparticles, nickel nanoparticles, rhodium nanoparticles and combinations thereof, particularly copper nanoparticles. The first metal nanoparticles are typically substantially pure single metals, although metal alloys may also be used.

Examples of the second metal nanoparticles include copper nanoparticles, silver nanoparticles, gold nanoparticles, platinum nanoparticles, palladium nanoparticles, nickel nanoparticles, rhodium nanoparticles. The second metal nanoparticles are typically substantially pure single metals, although metal alloys may also be used.

The first metal nanoparticles are different from the second metal nanoparticles. For example, the depositing solution may be comprised of a first copper nanoparticle and a second silver nanoparticle or a second silver nanoparticle precursor, a first copper nanoparticle and a second gold nanoparticle or a second gold nanoparticle precursor, or the first metal nanoparticle is a silver nanoparticle and the second material is a gold metal nanoparticle or a gold nanoparticle precursor.

The concentration of the first metal nanoparticles in the depositing solution is from about 5 weight percent to about 98 weight percent, such as, for example, from about 10 weight percent to about 95 weight percent, or from about 15 weight percent to about 90 weight percent, of the total nanoparticle weight percent in the depositing solution.

If the depositing solution is a mixture of first metal nanoparticles and second metal nanoparticles, the concentration of the second metal nanoparticles in the depositing solution is from about 2 weight percent to about 90 weight percent, such as, for example, from about 5 weight percent to about 85 weight percent, from about 10 weight percent to about 70 weight percent, or from about 15 weight percent to about 50 weight percent, of the total nanoparticle weight product depositing solution.

If the depositing solution is comprised of first metal nanoparticles and a soluble second metal nanoparticle precursor, the solution at deposition and the substrate following deposition of the depositing solution, will most likely not contain second metal nanoparticles until the substrate is subjected, prior to the heating to a temperature below about 90 °C, such as, for example, 40 °C to about 90 °C, from about 50 °C to about 85 °C, from about 50 °C to about 80 °C or from about 50 °C to about 75 °C. This additional step destabilizes the soluble second metal nanoparticle precursor and forms *in situ* the second metal nanoparticles that, upon further heating, anneal the second metal nanoparticles to form a conductive layer with the first metal nanoparticles on the substrate.

The soluble second metal nanoparticle precursor is comprised of a metal compound that is soluble in a solvent, or soluble in a solvent with the assistance of a complex agent such as, for example, an organoamine. Examples of the metal in the metal compound include silver, gold, copper, platinum, palladium, nickel, rhodium and combinations thereof. Examples of the metal compounds for the soluble second metal nanoparticle precursor include metal acetate, metal carbonate, metal chlorate, metal chloride, metal lactate, metal nitrate, metal pertafluoropropionate, metal trifluoroacetate, metal trifluoromethanesulfonate, and combinations thereof. Examples of the solvent used to solubilize the metal include any suitable ammonium carbamate, ammonium carbonate or ammonium bicarbonate such as, for example, 2-ethylhexylammonium 2-ethylhexylcarbamate, 2-ethylhexylammonium 2-ethylhexylcarbonate, n-butylammonium n-butylcarbonate, cyclohexylammonium cyclohexylcarbamate, benzylammonium carbamate, 2-methoxyethylammonium 2 methoxyethylbicarbonate, isopropylammonium isopropylbicarbonate and combinations thereof. Examples of the complex agent used to solubilize the metal compounds include organic amines such as ethanolamine, aminopropanol, diethanolamine, 2-methylaminoethanol, N,N-dimethylaminoethanol, methoxyethylamine, methoxypropylamine, diaminoethane, diaminopropane, diaminobutane, diaminocyclohexane, and a mixture thereof, thiols (CₙH₂ₙ₊₁SH, where 2 ≤ n ≤ 20), carboxylic acid, pyridyl and organophosphine. An example of the soluble second metal nanoparticle precursor are silver ink precursors available from Inktec described in WO 2006/093398.

Any suitable liquid or solvent may be used for the depositing solution, for example, organic solvents and water. For example, the liquid solvent may comprise an alcohol such as, for example, methanol, ethanol, propanol, butanol, pentanol, hexanol, heptanol, octanol or combinations thereof; a hydrocarbon such as, for example, pentane, hexane, cyclohexane, heptane, octane, nonane, decane, undecane, dodecane, tridecane, tetradecane, toluene, benzene, xylene, mesitylene, tetrahydrofuran, chlorobenzene, dichlorobenzene, trichlorobenzene, nitrobenzene, cyanobenzene, acetonitrile, or combinations thereof. Specific examples of suitable solvent or carrier media include, without limitation, N,N,-dimethylacetamide (DMAc), diethyleneglycol butylether (DEGBE), ethanolamine and N-methyl pyrrolidone, dichloromethane, MEK, toluene, ketones, benzene, chlorotoluene, nitrobenzene, dichlorobenzene, NMP (N-methylpyrrolidinone), DMA (dimethylacetamide), ethylene glycol, diethylene glycol, DEGBE (diethylene glycol butyl ether), and propylene glycol. The volume of the solvent in the depositing solution is, for example, from about 10 weight percent to about 98 weight percent, from about 50 weight percent to about 90 weight percent and from about 60 weight percent to about 85 weight percent.

One, two, three or more solvents may be used in the depositing solution. In embodiments where two or more solvents are used, each solvent may be present at any suitable volume ratio or molar ratio such as for example from about 99(first solvent):1(second solvent) to about 1 (first solvent):99(second solvent).

Due to the larger size of the first metal nanoparticles, they do not require stabilizers. However, due to the high reactivity and small size, the second metal nanoparticles may require a stabilizer. A variety of stabilizers may be used which have the function of minimizing or preventing the metal nanoparticles from aggregation in a liquid and optionally providing the solubility or dispersibility of metal nanoparticles in a liquid. In addition, the stabilizer is associated with the surface of the second metal nanoparticles and is not removed until the annealing of the second metal nanoparticles during formation of conductive features on a substrate.

Organic stabilizers may be used to stabilize the second metal nanoparticles. The term "organic" in "organic stabilizer" refers to, for example, the presence of carbon atom(s), but the organic stabilizer may include one or more non-metal heteroatoms such as nitrogen, oxygen, sulfur, silicon, halogen, and the like. Examples of other organic stabilizers may include, for example, thiol and its derivatives, -OC(=S)SH (xanthic acid), dithiocarbonates, polyethylene glycols, polyvinylpyridine, polyninylpyrolidone, alkyl xanthate, ether alcohol based xanthate, amines, and other organic surfactants. The organic stabilizer may be selected from the group consisting of a thiol such as, for example, butanethiol, pentanethiol, hexanethiol, heptanethiol, octanethiol, decanethiol, and dodecanethiol; a dithiol such as, for example, 1,2-ethanedithiol, 1,3-propanedithiol, and 1,4-butanedithiol; or a mixture of a thiol and a dithiol. The organic stabilizer may be selected from the group consisting of a xanthic acid such as, for example, O-methylxanthate, O-ethylxanthate, O-propylxanthic acid, O-butylxanthic acid, O-pentylxanthic acid, O-hexylxanthic acid, O-heptylxanthic acid, O-octylxanthic acid, O-nonylxanthic acid, O-decylxanthic acid, O-undecylxanthic acid, O-dodecylxanthic acid and combinations thereof.

Due to the smaller size of the second metal nanoparticles, they are able to locate between the larger, first metal nanoparticles upon deposition of the solution on a substrate. The first metal nanoparticles and the second metal nanoparticles are then heated to a temperature less than about 140 °C where only the second metal nanoparticles are "annealed", rendering the first metal nanoparticles and the second metal nanoparticles suitable for a large variety of substrates. The first metal nanoparticles have a higher annealing temperature and will not anneal at a temperature less than about 140 °C. Upon annealing, the second metal nanoparticles act as a conductive "glue" with the first metal nanoparticles and form a conductive path between the first metal nanoparticles.

In embodiments, the substrate having the depositing solution thereon or thereover may be annealed by heating the substrate during or following liquid depositing to a temperature of, for example, from about room temperature to about 140 °C, such as from about 40 °C to about 140 °C, from about 50 °C to about 120 °C, from about 50 °C to about 110 °C, from about 55 °C to about 100 °C and from about 55 °C to about 90 °C to anneal the small, second metal nanoparticles of the depositing solution and/or to remove any residual solvent and/or reaction by-products. Upon annealing, the second metal nanoparticles form a conductive path with the first metal nanoparticles.

The fabrication of an electrically conductive element from a depositing solution can be carried out by depositing the depositing solution on or over a substrate using any liquid deposition technique at any suitable time prior to or subsequent to the formation of other optional layer or layers on the substrate. Thus, liquid deposition of the depositing solution on the substrate can occur either directly on a substrate or on a substrate already containing layered material, for example, a semiconductor layer and/or an insulating layer.

The substrate may be composed of, for example, silicon, glass plate, plastic film or sheet. For structurally flexible devices, a plastic substrate, such as, for example, polyester, polycarbonate, polyethylene, polyimide sheets and the like may be used. The thickness of the substrate may be from amount 10 micrometers to about 10 millimeters, from about 50 micrometers to about 2 millimeters, especially for a flexible plastic substrate and from about 0.4 millimeters to about 10 millimeters for a rigid substrate such as glass or silicon.

The phrases "liquid deposition technique" or "liquid depositing" refer to, for example, the deposition of the depositing solution using a liquid process such as liquid coating or printing. The depositing solution may be referred to as ink when printing is used. Examples of liquid coating processes may include, for example, spin coating, blade coating, rod coating, dip coating, and the like. Examples of printing techniques may include, for example, lithography or offset printing, gravure, flexography, screen printing, stencil printing, inkjet printing, stamping (such as microcontact printing), and the like. Liquid deposition deposits a layer comprising the first metal nanoparticles and second metal nanoparticles, for example, having a thickness ranging from about 5 nanometers to about 5 micrometers, such as from about 10 nanometers to about 1000 nanometers, which, at this stage, may or may not exhibit appreciable electrical conductivity.

In embodiments, liquid deposition may implemented by using an inkjet printer, which may include a single reservoir containing the depositing solution.

In embodiments, the depositing solution can be spin-coated, for example, for about 10 seconds to about 1000 seconds, for about 50 seconds to about 500 seconds or from about 100 seconds to about 150 seconds, onto a substrate at a speed, for example, from about 100 revolutions per minute ("rpm") to about 5000 rpm, from about 500 rpm to about 3000 rpm and from about 500 rpm to about 2000 rpm.

In embodiments, a depositing solution comprised of a mixture of first metal nanoparticles with an average diameter of about 50 nm to about 1000 nm and second metal nanoparticles with an average diameter of about 0.5 to about 20 nm is liquid deposited onto a substrate. The depositing solution is heated to a temperature below about 140 °C to anneal the second metal nanoparticles and thus form a conductive trace with the first metal nanoparticles.

As a way of illustrating this embodiment, Figure 1, for convenience, displays the depositing solution after being liquid deposited onto a substrate (30). In Figure 1, the first metal nanoparticles (10) and the second metal nanoparticles (20) of the depositing solution are liquid deposited onto the substrate (30). The first metal nanoparticles (10) and the second metal nanoparticles (20) of the depositing solution are heated to a temperature below about 140 °C (step 40) to anneal the second metal nanoparticles and form a conductive annealed path (50), and thus form a conductive trace (80) with the first metal nanoparticles (10) on the surface of the substrate (30).

In embodiments, a depositing solution comprised of a mixture of first metal nanoparticles with an average diameter of about 50 nm to about 800 nm and a soluble second metal nanoparticle precursor is liquid deposited onto a substrate. The depositing solution is subjected to a temperature below about 90 °C to destabilize the soluble second metal nanoparticle precursor and form second metal nanoparticles. The first metal nanoparticles and the second metal nanoparticles are further heated to a temperature below about 140 °C to anneal the second metal nanoparticles and thus form a conductive trace with the first metal nanoparticles. The destabilization heating step and the annealing heating step may be done at the same temperature.

As a way of illustrating this embodiment, Figure 2, for convenience, displays the depositing solution after being liquid deposited onto a substrate (30). In Figure 2, the first metal nanoparticles (10) and the soluble second metal nanoparticle precursor (60) of the depositing solution are liquid deposited onto the substrate (30). The depositing solution after deposition is heated to a temperature below about 90 °C (step 70) to destabilize the soluble second metal nanoparticle precursor (60) and form second metal nanoparticles (20). The first metal nanoparticles (10) and the second metal nanoparticles (20) are then heated to a temperature below about 140 °C (step 40) to anneal the second metal nanoparticles and form a conductive annealed path (50), and thus form a conductive trace (80) with the first metal nanoparticles (10) on the surface of the substrate (30).

Any suitable liquid or solvent may be used to wash the conductive features to remove any residual solvent and/or by-products from the reaction of the silver compound solution and the hydrazine compound reducing agent solution, such as, for example, organic solvents and water. For example, the solvent may comprise, for example, hydrocarbon solvents such as pentane, hexane, cyclohexane, heptane, octane, nonane, decane, undecane, dodecane, tridecane, tetradecane, toluene, xylene, mesitylene, methanol, ethanol, propanol, butanol, pentanol, hexanol, acetone, methyethylketone, tetrahydrofuran; dichloromethane, chlorobenzene; dichlorobenzene; trichlorobenzene; nitrobenzene; cyanobenzene; N,N-dimethylformamide, acetonitrile; or mixtures thereof.

### EXAMPLE 1: Preparation of Large Copper Nanoparticles

A 0.1 M aqueous solution of copper (II) chloride (CuCl₂) was mixed with 0.2 M solution of bis(2-ethylhexyl) hydrogen phosphate (HDEHP) in heptane for 12 hours at 25 °C to produce a biphasic suspension. A 0.6 M solution of sodium borohydride (NaBH₄) was added drop-wise to reduce the CuCl₂ to form large copper nanoparticles. The final product was isolated as a black powder with a mean particle diameter of 60 nm as determined by scanning electron microscopy (SEM).

### EXAMPLE 2: Preparation of Large Copper Nanoparticles

A 20 nM solution of copper (II) acetylacetonate in octyl ether was added into a stirred 60 mM solution of 1,2-hexadecanediol with stirring to form a mixture. The mixture was heated to 105 °C under argon (Ar) gas for 10 minutes and subsequently followed by the addition of oleic acid and olyelyamine to form a 20 mM solution of each within the reaction mixture.

The reaction mixture was heated to a temperature from about 150 °C to 210 °C for 30 minutes. Finally, an ethanol solution was added to precipitate the copper nanoparticles. These copper nanoparticles were collected by vacuum filtration.

Copper nanoparticles collected by this method exhibited a mean particle diameter of 5 to 25 nm as determined by transmission electron microscopy (TEM).

### EXAMPLE 3: Preparation of Small Silver Nanoparticles

Silver acetate (0.167 g, 1 mmol) and 1-dodecylamine (3.71 g, 20 mmol) were first dissolved in toluene (100 mL) by heating at 60 °C until silver acetate was dissolved. To this solution was added a solution of phenylhydrazine (0.43 g, 4 mmol) in toluene (50 mL) with vigorous stirring over a period of 10 min. The resulting reaction mixture was stirred at 60 °C for 1 hr before cooling down to room temperature.

Subsequently, acetone (10 mL) was added to the reaction mixture to destroy excess phenylhydrazine. Solvent removal from the reaction mixture gave a residue which was added to stirring methanol (100 mL) to precipitate the crude silver nanoparticle products. The crude silver nanoparticle product was isolated by centrifugation, washed with acetone twice, and air-dried. Silver nanoparticle prepared using this technique exhibited a mean particle diameter of 5 nm as determined by TEM.

### EXAMPLE 4: Printing and Annealing of Nanoparticles (Large Copper Nanoparticles - Small Silver Nanoparticles)

A 1 gram mixture a 10 weight percent bimetallic ink was prepared by mixing 0.95 grams of the copper nanoparticles prepared from Example 1 or 2 and 0.05 g of the silver nanoparticles prepared from Example 3 in 10 mL of a xylene solvent, forming a depositing solution. The solution was then printed using a Dimatix inkjet printer on a polyethylene terephthalate (PET) plastic sheet. The PET plastic sheet was heated to 140 °C for 10 minutes where the silver nanoparticle annealed around the copper nanoparticles to form a continuous conductive trace.

### EXAMPLE 5: Printing and Annealing of Nanoparticles (Large Copper Nanoparticles - Soluble Silver Precursor)

A 1 gram mixture a 10 weight percent bimetallic ink was prepared by mixing 0.95 grams of the copper nanoparticles prepared from Example 1 or 2 with 0.05 g of a soluble silver precursor (such as Inktec IJP-010 ink manufactured by Inktec) in 10mL of a xylene solvent. The mixture was then printed using a Dimatix inkjet printer on a polyethylene terephthalate (PET) plastic sheet. The PET plastic sheet was heated to 80 °C for 1 minute to destabilize the soluble silver precursor and form silver nanoparticles. The printed ink darkened considerably at this stage. The PET plastic sheet was once again heated to 140 °C for 10 minutes where *in situ* the silver nanoparticle annealed around the copper nanoparticles to form a continuous conductive trace.

It will be appreciated that various of the above-disclosed and other features and functions, or alternatives thereof, may be desirably combined into many other different systems or applications. Also, various presently unforeseen or unanticipated alternatives, modifications, variations or improvements therein may be subsequently made by those skilled in the art, and are also intended to be encompassed by the following claims.

## Claims

1. A method of forming conductive features on a substrate, the method comprising:
providing a depositing solution,
liquid depositing the depositing solution onto a substrate (30), and
heating the depositing solution to a temperature below 140°C, wherein the depositing solution comprises first metal nanoparticles (10), wherein the average diameter of the first metal nanoparticles (10) is from 50 nm to 800 nm, **characterized in that**
the depositing solution is comprised of a mixture of first metal nanoparticles (10) and second metal nanoparticles (20) or a combination of first metal nanoparticles (10) and a soluble second metal nanoparticle precursor (60),
wherein the first metal nanoparticles (10) are different from the second metal nanoparticles (20),
wherein if the depositing solution is a combination of the first metal nanoparticles (10) and the soluble second metal nanoparticle precursor (60), the method further comprises: subjecting the soluble second metal nanoparticle precursor (60) to a temperature at or below 90°C prior to the heating to a temperature below 140°C to destabilize the soluble second metal nanoparticle precursor (60) and form the second metal nanoparticles (20),
wherein the average diameter of the second metal nanoparticles (20) is from 0.5 nm to 20 nm, and
wherein the concentration of the first metal nanoparticles (10) is 5 to 98 wt % in the depositing solution and the concentration of the second metal nanoparticles (20) is 2 to 90 wt % in the depositing solution.

2. A method of forming conductive features on a substrate according to claim 1, wherein the depositing solution is comprised of a mixture of first metal nanoparticles (10) and second metal nanoparticles (20).

3. A method of forming conductive features on a substrate according to claim 1,
wherein the depositing solution is comprised of a combination of first metal nanoparticles (10) and a soluble second metal nanoparticle precursor (60),
and wherein said heating the depositing solution step is to a temperature below 100°C.

4. The method according to any preceding claim, wherein the first metal nanoparticles (10) are selected from the group consisting of copper nanoparticles, silver nanoparticles, gold nanoparticles, platinum nanoparticles, palladium nanoparticles, nickel nanoparticles, rhodium nanoparticles and combinations thereof.

5. The method according to any of claims 1, 2, or 4 wherein the second metal nanoparticles (20) are selected from the group consisting of copper nanoparticles, silver nanoparticles, gold nanoparticles, platinum nanoparticles, palladium nanoparticles, nickel nanoparticles, rhodium nanoparticles and combinations thereof.

6. The method according to claim 1, 3 or 4, wherein the metal in the soluble second metal nanoparticle precursor (60) is selected from the group consisting of silver, gold, copper, platinum, palladium, nickel, rhodium and combinations thereof.

7. The method according to any preceding claim, wherein the first metal nanoparticles (10) are copper nanoparticles and the second metal nanoparticles (20) are silver nanoparticles.

8. The method according to any preceding claim, wherein the average diameter of the first metal nanoparticles (10) is from 50 nm to 200 nm and the average diameter of the second metal nanoparticles (20) is from 0.5 nm to 10 nm.

9. The method according to any preceding claim, wherein the depositing solution is heated at a temperature below 140°C to anneal the second metal nanoparticles (20) and form a conductive path with the first metal nanoparticles (10).

10. The method according to any preceding claim, wherein the liquid depositing is selected from the group consisting of spin coating, blade coating, rod coating, dip coating, lithography or offset printing, gravure, flexography, screen printing, stencil printing, inkjet printing and stamping.

11. The method according to any preceding claim, wherein the substrate (30) is comprised of silicon, glass, metal oxide, plastic, fabric, paper or combinations thereof, preferably wherein the substrate (30) is comprised of plastic with a melting point greater than 140°C.

12. The method according to any preceding claim, wherein the solvent for the depositing solution is selected from the group consisting of water, pentane, hexane, cyclohexane, heptane, octane, nonane, decane, undecane, dodecane, tridecane, tetradecane, toluene, xylene, mesitylene, methanol, ethanol, propanol, butanol, pentanol, hexanol, heptanol, octanol, tetrahydrofuran, chlorobenzene, dichlorobenzene, trichlorobenzene, nitrobenzene, cyanobenzene, acetonitrile, dichloromethane, N,N-dimethylformamide (DMF) and combinations thereof.

13. A metallic nanoparticle solution comprised of
a first metal nanoparticle (10) wherein the average diameter of the first metal nanoparticle (10) is from 50 nm to 800 nm **characterized in that** the metallic nanoparticle solution further comprises a second metal material selected from one of a second metal nanoparticle (20) and a second metal nanoparticle precursor (60) that forms a second metal nanoparticle (20) upon heating to a temperature at or below 90°C, wherein the first metal nanoparticles (10) are different from the second metal nanoparticles (20),
wherein the average diameter of the first metal nanoparticle (10) is from 50 nm to 800 nm wherein the average diameter of the second metal nanoparticle (20), when present or formed, is from 0.5 nm to 20 nm, and wherein the concentration of the first metal nanoparticles (10) is 5 to 98 wt % in the depositing solution and the concentration of the second metal nanoparticles (20) is 2 to 90 wt % in the depositing solution.

14. The metallic nanoparticle solution according to claim 13, further comprising the additional features of any of claims 4 to 8.

## Patentansprüche

1. Verfahren zum Bilden von leitfähigen Merkmalen auf einem Substrat, wobei das Verfahren umfasst:
das Bereitstellen einer Abscheidungslösung,
das Flüssigabscheiden der Abscheidungslösung auf ein Substrat (30), und
das Erwärmen der Abscheidungslösung auf eine Temperatur unter 140 °C, wobei die Abscheidungslösung erste Metallnanoteilchen (10) umfasst, wobei der mittlere Durchmesser der ersten Metallnanoteilchen (10) 50 nm bis 800 nm beträgt,
**dadurch gekennzeichnet, dass**
die Abscheidungslösung eine Mischung von ersten Metallnanoteilchen (10) und zweiten Metallnanoteilchen (20) oder eine Kombination von ersten Metallnanoteilchen (10) und einer löslichen Vorstufe (60) von zweiten Metallnanoteilchen umfasst,
wobei die ersten Metallnanoteilchen (10) von den zweiten Metallnanoteilchen (20) verschieden sind,
wobei, wenn die Abscheidungslösung eine Kombination von den ersten Metallnanoteilchen (10) und der löslichen Vorstufe (60) von zweiten Metallnanoteilchen ist, das Verfahren außerdem umfasst: das Aussetzen der löslichen Vorstufe (60) von zweiten Metallnanoteilchen einer Temperatur von oder unter 90 °C vor dem Erwärmen auf eine Temperatur unter 140 °C, um die lösliche Vorstufe (60) von zweiten Metallnanoteilchen zu destabilisieren und die zweiten Metallnanoteilchen (20) zu bilden,
wobei der mittlere Durchmesser der zweiten Metallnanoteilchen (20) 0,5 nm bis 20 nm beträgt, und
wobei die Konzentration der ersten Metallnanoteilchen (10) 5 bis 98 Gew.-% in der Abscheidungslösung beträgt und die Konzentration der zweiten Metallnanoteilchen (20) 2 bis 90 Gew.-% in der Abscheidungslösung beträgt.

2. Verfahren zum Bilden von leitfähigen Merkmalen auf einem Substrat nach Anspruch 1, wobei die Abscheidungslösung eine Mischung von ersten Metallnanoteilchen (10) und zweiten Metallnanoteilchen (20) umfasst.

3. Verfahren zum Bilden von leitfähigen Merkmalen auf einem Substrat nach Anspruch 1, wobei die Abscheidungslösung eine Kombination von ersten Metallnanoteilchen (10) und einer löslichen Vorstufe (60) von zweiten Metallnanoteilchen umfasst,
und wobei das Erwärmen der Abscheidungslösung auf eine Temperatur unter 100 °C erfolgt.

4. Verfahren nach einem vorhergehenden Anspruch, wobei die ersten Metallnanoteilchen (10) ausgewählt sind aus der Gruppe bestehend aus Kupfernanoteilchen, Silbernanoteilchen, Goldnanoteilchen, Platinnanoteilchen, Palladiumnanoteilchen, Nickelnanoteilchen, Rhodiumnanoteilchen und Kombinationen davon.

5. Verfahren nach einem der Ansprüche 1, 2 oder 4, wobei die zweiten Metallnanoteilchen (20) ausgewählt sind aus der Gruppe bestehend aus Kupfernanoteilchen, Silbernanoteilchen, Goldnanoteilchen, Platinnanoteilchen, Palladiumnanoteilchen, Nickelnanoteilchen, Rhodiumnanoteilchen und Kombinationen davon.

6. Verfahren nach Anspruch 1, 3 oder 4, wobei das Metall in der löslichen Vorstufe (60) von zweiten Metallnanoteilchen ausgewählt ist aus der Gruppe bestehend aus Silber, Gold, Kupfer, Platin, Palladium, Nickel, Rhodium und Kombinationen davon.

7. Verfahren nach einem vorhergehenden Anspruch, wobei die ersten Metallnanoteilchen (10) Kupfernanoteilchen sind und die zweiten Metallnanoteilchen (20) Silbernanoteilchen sind.

8. Verfahren nach einem vorhergehenden Anspruch, wobei der mittlere Durchmesser der ersten Metallnanoteilchen (10) 50 nm bis 200 nm beträgt und der mittlere Durchmesser der zweiten Metallnanoteilchen (20) 0,5 nm bis 10 nm beträgt.

9. Verfahren nach einem vorhergehenden Anspruch, wobei die Abscheidungslösung auf eine Temperatur unter 140 °C erwärmt wird, um die zweiten Metallnanoteilchen (20) zu annealen und mit den ersten Metallnanoteilchen (10) eine Leiterbahn zu bilden.

10. Verfahren nach einem vorhergehenden Anspruch, wobei das Flüssigabscheiden ausgewählt ist aus der Gruppe bestehend aus Schleuderbeschichten, Rakelstreichen, Stabstreichen, Tauchbeschichten, Lithographie oder Offsetdruck, Tiefdruck, Flexographie, Siebdruck, Schablonendruck, Tintenstrahldruck und Stempeln.

11. Verfahren nach einem vorhergehenden Anspruch, wobei das Substrat (30) Silicium, Glas, Metalloxid, Kunststoff, Gewebe, Papier oder Kombinationen davon umfasst, vorzugsweise wobei das Substrat (30) Kunststoff mit einem Schmelzpunkt von mehr als 140 °C umfasst.

12. Verfahren nach einem vorhergehenden Anspruch, wobei das Lösungsmittel für die Abscheidungslösung ausgewählt ist aus der Gruppe bestehend aus Wasser, Pentan, Hexan, Cyclohexan, Heptan, Octan, Nonan, Decan, Undecan, Dodecan, Tridecan, Tetradecan, Toluol, Xylol, Mesitylen, Methanol, Ethanol, Propanol, Butanol, Pentanol, Hexanol, Heptanol, Octanol, Tetrahydrofuran, Chlorbenzol, Dichlorbenzol, Trichlorbenzol, Nitrobenzol, Cyanobenzol, Acetonitril, Dichlormethan, N,N-Dimethylformamid (DMF) und Kombinationen davon.

13. Metallnanoteilchenlösung umfassend
ein erstes Metallnanoteilchen (10), wobei der mittlere Durchmesser des ersten Metallnanoteilchens (10) 50 nm bis 800 nm beträgt,
**dadurch gekennzeichnet, dass**
die Metallnanoteilchenlösung außerdem ein zweites Metallmaterial ausgewählt aus einem von einem zweiten Metallnanoteilchen (20) und einer Vorstufe (60) von zweiten Metallnanoteilchen, welche ein zweites Metallnanoteilchen (20) beim Erwärmen auf eine Temperatur von oder unter 90°C bildet, umfasst, wobei die ersten Metallnanoteilchen (10) von den zweiten Metallnanoteilchen (20) verschieden sind,
wobei der mittlere Durchmesser des ersten Metallnanoteilchens (10) 50 nm bis 800 nm beträgt, wobei der mittlere Durchmesser des zweiten Metallnanoteilchens (20), wenn es vorhanden ist oder gebildet wird, 0,5 nm bis 20 nm beträgt und wobei die Konzentration der ersten Metallnanoteilchen (10) 5 bis 98 Gew.-% in der Abscheidungslösung beträgt und die Konzentration der zweiten Metallnanoteilchen (20) 2 bis 90 Gew.-% in der Abscheidungslösung beträgt.

14. Metallnanoteilchenlösung nach Anspruch 13, außerdem umfassend die zusätzlichen Merkmale von beliebigen der Ansprüche 4 bis 8.

## Revendications

1. Procédé de formation de caractéristiques de conduction sur un substrat, le procédé comprenant :
la prévision d'une solution de déposition,
la déposition en phase liquide de la solution de déposition sur un substrat (30), et
le chauffage de la solution de déposition à une température inférieure à 140°C, dans lequel la solution de déposition comprend des nanoparticules d'un premier métal (10), dans lequel le diamètre moyen des nanoparticules d'un premier métal (10) est de 50 nm à 800 nm, **caractérisé en ce que**
la solution de déposition est constituée d'un mélange de nanoparticules d'un premier métal (10) et de nanoparticules d'un deuxième métal (20) ou d'une combinaison de nanoparticules d'un premier métal (10) et d'un précurseur soluble (60) de nanoparticules d'un deuxième métal,
dans lequel les nanoparticules d'un premier métal (10) sont différentes des nanoparticules d'un deuxième métal (20),
dans lequel, si la solution de déposition est une combinaison des nanoparticules d'un premier métal (10) et du précurseur soluble (60) de nanoparticules d'un deuxième métal, le procédé comprend en outre : la soumission du précurseur soluble (60) de nanoparticules d'un deuxième métal à une température de ou inférieure à 90°C avant le chauffage à une température inférieure à 140°C afin de déstabiliser le précurseur soluble (60) de nanoparticules d'un deuxième métal et de former les nanoparticules d'un deuxième métal (20),
dans lequel le diamètre moyen des nanoparticules d'un deuxième métal (20) est de 0,5 nm à 20 nm, et
dans lequel la concentration des nanoparticules d'un premier métal (10) est 5 à 98% en poids dans la solution de déposition et la concentration des nanoparticules d'un deuxième métal (20) est 2 à 90% en poids dans la solution de déposition.

2. Procédé de formation de caractéristiques de conduction sur un substrat selon la revendication 1, dans lequel la solution de déposition est constituée d'un mélange de nanoparticules d'un premier métal (10) et de nanoparticules d'un deuxième métal (20).

3. Procédé de formation de caractéristiques de conduction sur un substrat selon la revendication 1,
dans lequel la solution de déposition est constituée d'une combinaison de nanoparticules d'un premier métal (10) et d'un précurseur soluble (60) de nanoparticules d'un deuxième métal,
et dans lequel ladite étape de chauffage de la solution de déposition est à une température inférieure à 100°C.

4. Procédé selon une quelconque revendication précédente, dans lequel les nanoparticules d'un premier métal (10) sont choisies parmi le groupe consistant en des nanoparticules de cuivre, des nanoparticules d'argent, des nanoparticules d'or, des nanoparticules de platine, des nanoparticules de palladium, des nanoparticules de nickel, des nanoparticules de rhodium et des combinaisons de celles-ci.

5. Procédé selon l'une quelconque des revendications 1, 2 ou 4 dans lequel les nanoparticules d'un deuxième métal (20) sont choisies parmi le groupe consistant en des nanoparticules de cuivre, des nanoparticules d'argent, des nanoparticules d'or, des nanoparticules de platine, des nanoparticules de palladium, des nanoparticules de nickel, des nanoparticules de rhodium et des combinaisons de celles-ci.

6. Procédé selon la revendication 1, 3 ou 4, dans lequel le métal dans le précurseur soluble (60) de nanoparticules d'un deuxième métal est choisi parmi le groupe consistant en l'argent, l'or, le cuivre, le platine, le palladium, le nickel, le rhodium et des combinaisons de ceux-ci.

7. Procédé selon une quelconque revendication précédente, dans lequel les nanoparticules d'un premier métal (10) sont des nanoparticules de cuivre et les nanoparticules d'un deuxième métal (20) sont des nanoparticules d'argent.

8. Procédé selon une quelconque revendication précédente, dans lequel le diamètre moyen des nanoparticules d'un premier métal (10) est de 50 nm à 200 nm et le diamètre moyen des nanoparticules d'un deuxième métal (20) est de 0,5 nm à 10 nm.

9. Procédé selon une quelconque revendication précédente, dans lequel la solution de déposition est chauffée à une température inférieure à 140°C afin de recuire les nanoparticules d'un deuxième métal (20) et de former un chemin de conduction avec les nanoparticules d'un premier métal (10).

10. Procédé selon une quelconque revendication précédente, dans lequel la déposition en phase liquide est choisie parmi le groupe consistant en un revêtement à la tournette, un revêtement à la lame, un revêtement à la barre, un revêtement par immersion, une lithographie ou une impression offset, une gravure, une flexographie, une sérigraphie, une impression au stencil, une impression à jet d'encre et un estampage.

11. Procédé selon une quelconque revendication précédente, dans lequel le substrat (30) est constitué de silicium, de verre, d'un oxyde de métal, d'un plastique, d'une étoffe, d'un papier ou de combinaisons de ceux-ci, préférablement dans lequel le substrat (30) est constitué d'un plastique ayant un point de fusion supérieur à 140°C.

12. Procédé selon une quelconque revendication précédente, dans lequel le solvant pour la solution de déposition est choisi parmi le groupe consistant en l'eau, le pentane, l'hexane, le cyclohexane, l'heptane, l'octane, le nonane, le décane, l'undécane, le dodécane, le tridécane, le tétradécane, le toluène, le xylène, le mésitylène, le méthanol, l'éthanol, le propanol, le butanol, le pentanol, l'hexanol, l'heptanol, l'octanol, le tétrahydrofurane, le chlorobenzène, le dichlorobenzène, le trichlorobenzène, le nitrobenzène, le cyanobenzène, l'acétonitrile, le dichlorométhane, le N,N-diméthylformamide (DMF) et de combinaisons de ceux-ci.

13. Solution de nanoparticules métalliques constituée de
une nanoparticule d'un premier métal (10) dans laquelle le diamètre moyen de la nanoparticule d'un premier métal (10) est de 50 nm à 800 nm **caractérisée en ce que** la solution de nanoparticules métalliques comprend en outre une deuxième matière métallique choisie parmi un parmi une nanoparticule d'un deuxième métal (20) et un précurseur (60) de nanoparticule d'un deuxième métal qui forme une nanoparticule d'un deuxième métal (20) lors d'un chauffage à une température de ou inférieure à 90°C, dans laquelle les nanoparticules d'un premier métal (10) sont différentes des nanoparticules d'un deuxième métal (20),
dans laquelle le diamètre moyen de la nanoparticule d'un premier métal (10) est de 50 nm à 800 nm, dans laquelle le diamètre moyen de la nanoparticule d'un deuxième métal (20), lorsqu'elle est présente ou formée, est de 0,5 nm à 20 nm, et dans laquelle la concentration des nanoparticules d'un premier métal (10) est 5 à 98% en poids dans la solution de déposition et la concentration des nanoparticules d'un deuxième métal (20) est 2 à 90% en poids dans la solution de déposition.

14. Solution de nanoparticules métalliques selon la revendication 13, comprenant en outre les caractéristiques additionnelles selon l'une quelconque des revendications 4 à 8.
